# EUROPEAN PATENT SPECIFICATION

(11) **EP 0 386 780 B1**
(45) Date of publication and mention of the grant of the patent: **03.01.1996**
(21) Application number: 90104528.6
(22) Date of filing: 09.03.1990
(51) Int. Cl.: G03F 7/038, G03F 7/039

(54) **Photosensitive composition**
Lichtempfindliche Zusammensetzung
Composition photosensible

(30) Priority: 10.03.1989 JP 58188/89
(43) Date of publication of application: 12.09.1990
(73) Proprietor: NIPPON PAINT CO., LTD., Osaka-shi Osaka 530 (JP)
(72) Inventor: Kawabata, Masami, Takatsuki-shi, Osaka (JP)
(74) Representative: Brauns, Hans-Adolf, Dr. rer. nat.

(56) References cited:
- DE-A- 3 825 738

## Description

The present invention relates to a photosensitive composition capable of optically forming an image and a polymer used for the same.

Negative type photosensitive compositions which utilize photo-initiated polymerization and photo-initiated cross-linking reaction have been widely used in various kinds of application, for example photoresist, ink and printing plates.

The negative type photosensitive compositions generally contain photopolymerizable polymers or oligomers which have acidic groups, such as carboxylic group, in the structure thereof. Since the acidic groups form salts by treating with an alkaline solution, non-exposed portions are dissolved away when treated with an alkaline solution, while exposed portions are polymerized by photo-initiated polymerization or photo-initiated cross-linking reaction and are remained as they are without being dissolved away even though they form salts. However, in fact the exposed portions are slightly dissolved away due to the formation of a salt to "reduce a film-thickness". Such the reduction of a film-thickness is disadvantageous in respect of sensitivity and image dissolution.

DE-A-38 257 38 describes an imaging layer on the basis of a polymer containing carboxyl groups which is decarboxylated by photoreaction in the presence or absence of a photo-sensitizer.

It is an object of the present invention to solve the before mentioned problem of the reduction of the film-thickness by an alkaline solution, by providing a negative type photosensitive composition having high sensitivity and high dissolution.

The invention is directed to a photosensitive composition comprising
(a) a polymer having a group represented by the following formula (I) or (II) in a main chain consisting of carbon-carbon bonds: 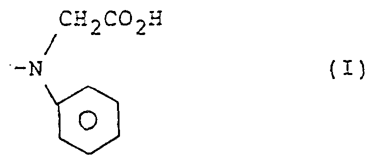 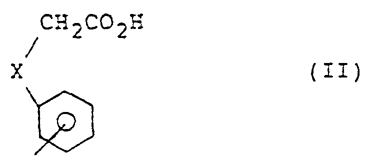 [wherein X is an oxygen atom, a sulfur atom or N-R¹,R¹ is a hydrogen atom, an alkyl group containing 1 to 3 carbon atoms or CH₂CO₂H.] said group being decarboxylated by photo-reaction of its own or by photo-reaction with a photo-sensitizer which absorbs a light to generate a free radical,
(b) a compound having an ethylenically unsaturated bond and
(c) a photosensitizer.

Since non-exposed portions of the photosensitive composition according to the present invention have carboxylic groups, they are dissovled away in the form of salts with an alkaline water. On the contrary, exposed portions lose carboxylic groups by an photodecarboxylation and their solubility to the alkaline water is remarkably reduced by the polymerization reaction through free radicals generated at this time. Thus, the exposed portions are not dissolved away, whereby the reduction of a film-thickness does not occur.

The polymer (hereinafter reffered to as a component A) according to the present invention includes polymers having the groups represented by the above described formula (I) or (II) as the free radical-generating portions, for example homopolymers of polymerizable compounds having these groups or copolymers of at least 2 kinds of such the polymerizable compound or copolymers of these polymerizable compounds and other copolymerizable compounds. The polymerizable compounds having the groups represented by the formula (I) or (II) include 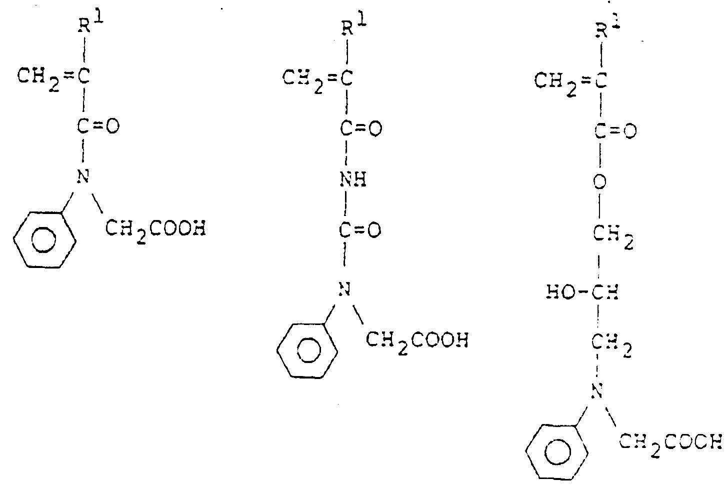 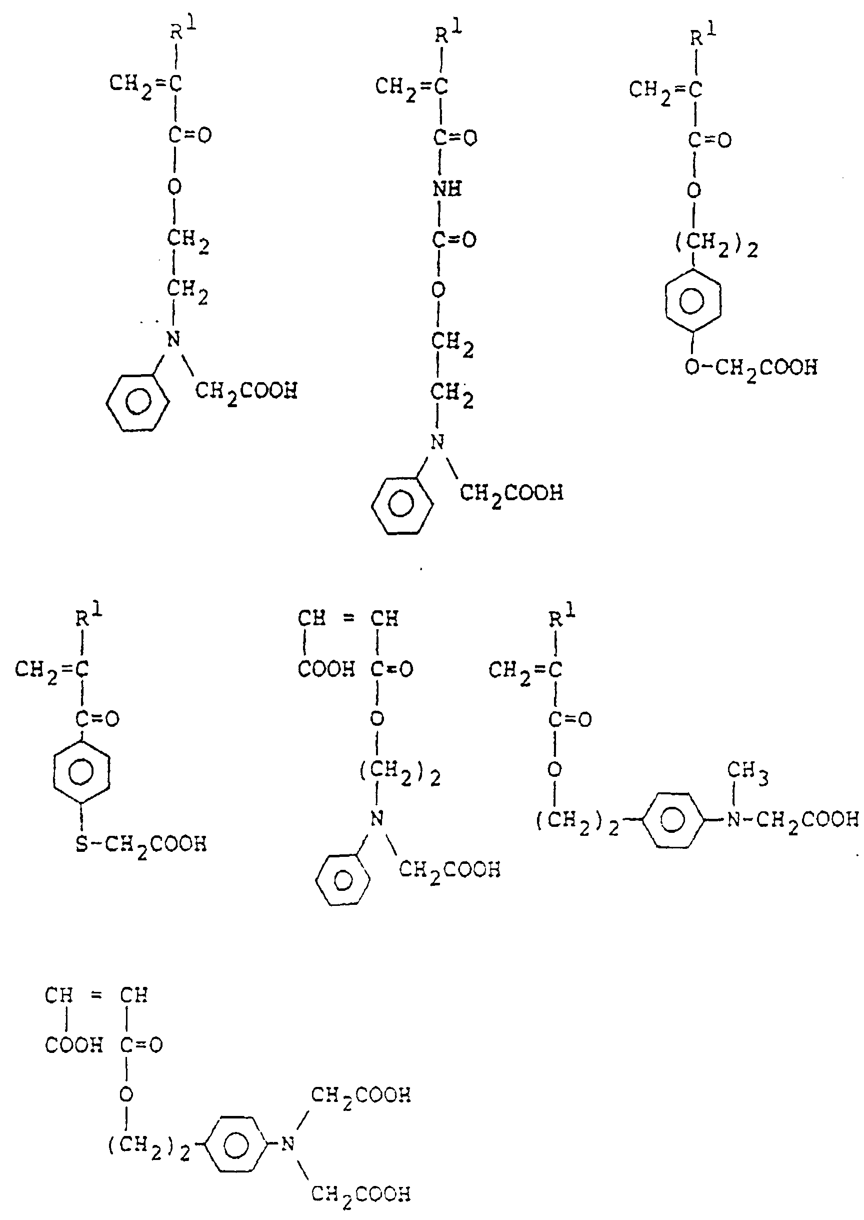 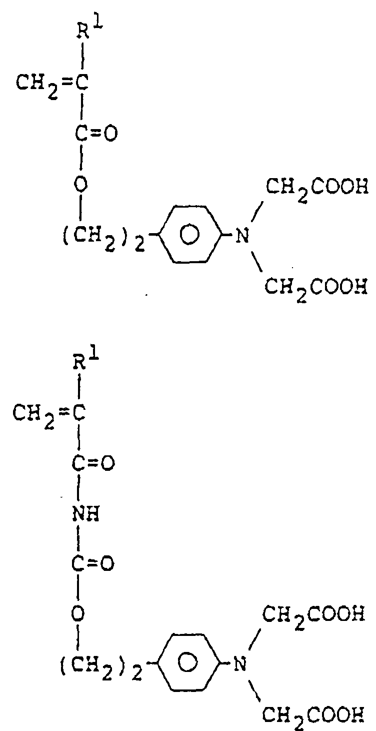 and the like (in the formula R¹ is a hydrogen or methyl group). Other copolymerizable compounds include acrylic acid, methacrylic acid, acrylic alkyl esters, methacrylic alkyl esters (containing a methyl-, ethyl-, n-propyl-, n-butyl-, iso-butyl-, 2-ethylhexyl group and the like as the alkyl groups), benzyl acrylate, benzyl methacrylate, acrylonitorile, styrene, itaconic acid, maleic acid, maleic alkyl esters (containing alkyl groups having 1 to 5 carbon atoms), maleic anhydride, vinyl chloride, vinylidene chloride, butadiene, vinyl alcohol, and vinyl acetate.

Further other polymers according to the present invention may be obtained by the reactions between a certain polymer having one of groups reactive with each other, and compounds having the other group of the groups reactive with each other and the groups represented by the above described formula (I) or (II). The groups reactive with each other include for example a carboxylic group and a hydroxylic group, a group having an activated hydrogen, (e.g. a hydroxyl group) and an epoxy group and the like. As to the reaction between the carboxylic group and the hydroxylic group, it is preferable that a copolymer of styrene and maleic anhydride is used as the certain polymer and N-phenyl-N-(2-hydroxyethyl)glycine is used as the compound having the above described reactive group and the groups represented by the formula (I) or (II).

In addition, the additional-polymerizable compounds (hereinafter referred to as a component B) having the ethylenically unsaturated double bonds used in the composition according to the present invention include unsaturated carboxylic acids, such as acrylic acid, methacrylic acid, itaconic acid and maleic acid; esters of the above described unsaturated carboxylic acids and polyhydroxylic compounds (e.g. a ethylene glycol, tetraethylene glycol, neopentyl glycol, propylene glycol, 1,2-butane diol, trimethylol propane, pentaerythritol and tripentaerythritol); addition products of the above described unsaturated carboxylic acid and polyepoxides, (e.g. trimethylolpropane triglycidyl ether, pentaerythritol polyglycidyl ether, propylene glycol diglycidyl ether, a reaction product of epichlorhydrine with 2,2-bis(4-hydroxyphenyl)propane and diglycidyl ester of phthalic acid); and acrylamides and methacrylamides such as acrylamide, ethylene-bis-acrylamide, ethylene-bis-methacrylamide, hexamethylene-bis-acrylamide and hexamethylene-bis-methacrylamide. Acrylesters or methacrylesters are preferably used.

In addition, the photosensitive composition according to the present invention contains a suitable photosensitizer (hereinafter referred to as a component C) in order to increase photosensitive speed and widen photosensitive wavelength range. The photosensitizers include aromatic ketones, such as benzophenone, 2-ethyl-anthraquinoen and 2,4-diethylthioxantone; polycyclic aromatic hydrocarbons, such as anthrancene, phenanthrene and perylene; general dyes, such as coumarin type dyes, Rose Bengal and eosin, as disclosed in Japanese Kokai Publication 180946/1988; xanthene or thioxanthene type dyes as disclosed in Japanese Kokai Publication 31848/1987 and Japanese Patent Application Ser. No. 285017/1987; cyanine type dyes as disclosed in Japanese Patent Application Ser. No. 117187/1988 and melocyanine type dyes as disclosed in Japanese Patent Application Ser. No. 113894/1987.

The component B is used in a quantity of up to 3 parts by weight, preferably 0.5 to 1.5 parts by weight, and the component C in a quantity of up to 0.2 parts by weight, preferably 0.05 to 0.15 parts by weight, based on 1 parts by weight of the component A. If the component B is used in a quantity larger than 3 parts by weight, for example a hardness of the exposed portions is apt to be reduced on account of the remaining nonreacted component B. If the component C is used in a quantity larger than 0.2 parts by weight, the photopolymerization in the lower layer of the exposed portions is apt to be insufficient.

In order to more increase photosensitive speed, the photosensitive composition according to the present invention may contain diaryliodonium salts, for example chlorides, bromides, tetrafluoroborates, hexafluorophosphates, hexafluoroarsenates, hexafluoroantimonates and the like of iodoniums, (e.g. diphenyliodonium, bis(p-chlorophenyl)iodonium, ditryliodonium, bis(p-t-butylphenyl)iodonium and bis(m-nitrophenyl)iodonium); or peroxyesters, for example t-butylperoxybenzoate, di-t-butyldiperoxyisophthalate, 2,5-dimethyl-2,5-di(benzoylperoxy)hexane, t-butylperoxymaleic acid, 3,3',4,4'-tetra(t-butylperoxycarbonyl)benzophenone, t-butylperoxyisopropylcarbonate; and the like, if necessary. In addition, high-molecular binders, thermal polymerization inhibitors, plasticizers, coloring agents and the like may also be used as additives. The high molecular binders aim at the improvement of various kinds of property, such as compativility, film-forming property, developing property and adhesion, and it is sufficient to variously select them depending upon the aims.

The composition according to the present invention may be prepared by the usual methods. For example, it can be prepared by mixing the above described essential components and optional component as they are or mixing with solvents (for example ketones, such as methyl ethyl ketone, acetone and cyclohexanone; esters, such as ethyl acetate, butyl acetate and ethylene glycol diacetate; aromatic solvents, such as toluene and xylene; cellosolves, such as methyl cellosolve, ethyl cellosolve and butyl cellosolve; alcohols, such as methanol, ethanol and propanol; ether, such as tetrahydrofurane and dioxane; and halogen containing solvents such as dichloromethane and chloroform) in for example a high-speed stirrer in a cool and dark place. The photosensitive layer of the present invention may be formed by applying said composition to the substrate by means of a bar coater or a spinner and then drying by usual methods. In addition, the known techniques for the protection of the surface and the prevention of bad influences, such as the reduction of sensitivity by oxygen, may be applied on the formed photosensitive layer. For example, the photosensitive layer may be coated with a separatable transparent cover sheet, waxy substances having a reduced permeability to oxygen, water-soluble or alkali-soluble polymers and the like.

Lasers, such as semiconductor laser, helium-neon laser, argon laser, helium-cadimium laser and crypton laser, and general light sources radiating visible rays and ultraviolet rays, such as superhigh voltage mercury-vapor lamp, high-voltage mercury-vapor lamp, middle-voltage mercury-vapor lamp, methal hydride lamp and tungsten lamp, can be used as the light source for making the above described photosensitive layer insoluble by radiating a light. Besides, in order to remove the photosensitive layer of the nonexposed portions after the radiation of lights, suitable solvents, for example a developer for use in an offset PS, capable of dissolving the photosensitive layer of the nonexposed portions may be used in addition to alkaline water such as an aqueous solution of sodium metasilicate, an aqueous solution of sodium carbonate, an aqueous solution of treithylamine, an aqueous solution of triethanolamine and an ammonia water.

Also, another image-forming method, in which a difference between a polarity of the nonexposed portions and a polarity of the exposed portions reduced by the removal of carbonic acid is utilized, can be used. That is to say, if a surface of the sample according to the present invention exposed through a positive film is treated with pigments and the like having a high polarity, the pigments are adsorbed or react upon mostly the nonexposed portions having a high polarity to obtain a positive image.

The photosensitive composition according to the present invention can be used for light-setting type paints, printing plates, resists for forming a print circuit, halogen, mather plates of hologram and the like.

The photosensitive composition according to the present invention does not reduce a film-thicknes after the development in the exposed portions and exhibits high sensitivity and image-dissolution.

### EXAMPLE

The present invention is illustrated by the following preparation examples and application examples which, however, are not to be construed as limiting the invention to their details.

### Preparation Example 1

A sodium salt of N-phenylglycine of 50 g (0.29 mol) was dissolved in water of 50 g and methanol of 50 g and then hydroquinone of 18 mg were added to the resulting solution. This solution was heated upto temperatures of 45 to 50 °C and glycidyl methacrylate of 41 g (0.29 mol) was added dropwise for 20 minutes with stirring followed by stirring for further 2 hours. Water of 200 g was added to the resulting solution and acidified with hydrochloric acid followed by filtrating and drying the resulting crystals. N-(2-hydroxy-3-methacryloxypropyl)-N-phenylglycine (hereinafter called GMA-NPG for short) of 45 g was obtained. Then GMA-NPG of 2.0 g, MMA (methyl methacrylate) of 14.0 g, EA (ethyl acrylate) of 2.4 g and MAA (methacrylic acid) of 1.6 g were dissolved in dimethylformamide of 80 g. 20 g of a 1 wt%-solution of benzoyl peroxide in dimethylformamide was added dropwise to the above described solution under an atmosphere of nitrogen at 70 °C followed by stirring for further 6 hours. After cooling, hexane of about 10 times in weight was added to dilute the solution, the resulting polymer being settled and collected, the collected polymer being dissolved in methalethylketone and settled again in hexane, and the settlings being filtrated and dried in a vacuum. A white powdery polymer was obtained. The numbered mean molecular weight of the obtained polymer was 25,000 and its acid value was 75. In addition, it was confirmed from the existence of an absorption having a peak at 300 nm in the UV absorption spectrum of this polymer that GMA was copolymerized with NPG.

### Preparation Example 2

Monochloroacetic acid of 72 g (0.76 mol) was dissolved in water of 200 g and an aqueous solution containing sodium hydroxide of 32 g (0.8 mol) was added dropwise to the above described solution. The resulting solution was heated up to 100 °C and p-hydroxyphenetyl alcohol of 104.9 g (0.76 mol) was added to the heated solution dropwise for 30 minutes with stirring. Then, after stirring for further 90 minutes at 100 °C and cooling, the resulting white crystals [p-(2-hydroxyethyl)phenoxyacetic acid] were filtrated and dried.

Subsequently, a copolymer of styrene and maleic anhydride (1:1) of 20 g, the above described p-(2-hydroxyethyl)phenoxyacetic acid of 3.2 g and tetra(n-butyl)ammonium chloride as a catalyst were dissolved in dehydrated dimethylformamide of 80 g and stirred for 3 hours at 120 °C followed by adding n-butyl alcohol of 100 g and stirring for 1 hour at 120 °C. After cooling, methanol of about 10 times in weight was added to dilute the solution, whereby settling a polymer, and the settlings were filtrated and dried. A white powdery polymer was obtained. The numbered mean molecular weight of the obtained polymer was 32,000 and its acid value was 220.

In addition, it was confirmed from the existence of an absorption by a symmetrical expansion and contraction of C-O-C of p-(2-hydroxyethyl)phenoxyacetic acid in the vicinity of 1,040 cm⁻¹ in the infrared absorption spectrum of this polymer that p-(2-hydroxyethyl)phenoxyacetic acid was subjected to an addition reaction.

### Preparation Example 3

20 g of GMA-NPG obtained according to Example 1 was dissolved in dimethylformamide of 80 g and a 2 wt%-solution of azo-bis-isobutylonitrile in dimetylformamide of 20 g was added to the above described solution dropwise at 70 °C under an atmosphere of nitrogen followed by stirring for further 6 hours. After cooling, hexane of about 10 times in weight was added to dilute the solution. The deposited polymer was filtrated and dried in a vacuum. A white powdery polymer was obtained. The numbered mean molecular weight of the obtained polymer was 8,000 and its acid value was 190.

### APPLICATION EXAMPLES

Photosensitive plates were produced by the use of photosensitive materials according to Examples and the conventional photosensitive material and tested on the sensitivity and the reduction of film-thickness.

### Application Example 1

The polymer obtained according to Preparation Example 1 of 1 g, pentaerythritol triacrylate of 1 g and 2,4-diethylthioxantone of 0.03 g were dissolved in methyl ethyl ketone of 10 g to obtain a photosensitive solution, which was applied to an aluminum substrate by means of a bar coater in a dried quantity of 2g/m, and dried for 4 minutes at 60°C in a dessicator. Additionally, an aqueous solution of polyvinyl alcohol (saponification degree: 88%, polymerization degree: 500) was applied to this photosensitive layer by means of a bar coater to form a protective layer of 2g/m. Subsequently, a negative film was overlapped on this photosensitive plate to be adhered closely to each other in a vacuum and irradiated with a light of a high-voltage mercury vapor lamp of 3 KW for 2 minutes from a distance of 60 cm and then an exclusive brush of 1 kg weight was reciprocated 100 times on this photosensitive plate with adding a 1 wt%-aqueous solution of sodium carbonate drop by drop in a "Gardener abrasion tester AB-601" (manufactured by Kamishima Works, Ltd.). After washing and drying, the observation was visually conducted with the results that the irradiated photosensitive layer was glossy and no reduction of film thickness was observed.

### Comparative Application Example 1

A photosensitive plate was produced and tested in the quite same manner as in Application Example 1 excepting that an acrylic polymer (MMA/EA/MMA=75/14/11; numbered mean molecular weight: 28,000; acid value:78) of 1 g and N-phenylglycine of 0.2 g were used in place of 1 g of the polymer obtained according to Example 1 with the result that no image could be obtained.

### Comparative Application Example 2

A photosensitive plate was produced and tested in the quite same manner as in Application Example 2 excepting that a acrylic polymer (same as in Comparative application Example 1) of 1 g and N-phenylglycine of 0.2 g were used in place of the polymer obtained according to Example 1 of 1 g. As a result, the irradiated photosensitive layer tested in the abrasion tester was not glossy at all in comparison with that in Application Example 2 and the reduction of film-thickness was observed.

### Application Example 2 to 5, Comparative Application

### Example 3 to 8

Photosensitive plates comprising photosensitive layers having the respective compositions shown in Table 1 were produced in the same manner as in Application Example 1. However, the photosensitizers and diphenyliodonium chloride were previously dispersed (partially dissolved) in methylcellosolve and then dissolved in methylethylketone.

A Step Tablet No. 2 (21 steps) manufactured by Eastman Kodak Corp. was put upon the above described photosensitive plates and irradiated with light having wavelength of about 490 nm (the intensity of light: 4.0 mW/cm) taken out through a filter Toshiba KL-49 from lights of a xenon lamp (150 W) manufacture by Ushio Electric Machinery Co., Ltd. for 30 seconds followed by developing with a 1 wt %-aqueous solution of sodium carbonate. "Sensitivity" was determined by calculating an exposure energy required for the hardening on the basis of a number of optically hardened steps. In addition, in order to investigate an alkaline water resistance of the irradiated photosensitive layer of the respective photosensitive plates, the photosensitive plate, which had been directly irradiated with the above described lights having wavelengths of about 490 nm for 5 seconds without passing through the step tablet, were treated in the same manner as in Application Example 1 in the "Gardener abrasion tester AB-601" shown in Application Example 1 followed by visually observing the irradiated photosensitive layer to evaluate the "alkaline water resistance (that is the resistance to the reduction of film-thickness) of the irradiated layer". The results of "the sensitivity" and "the alkaline water resistance of the irradiated layer" are shown in Table 1. In addition, in Comparative Application Examples, composites using mixtures of usual polymers and the compounds bringing about the decarboxylic reaction by irradiation without using the polymers having the portions bringing about the decarboxylic reaction by irradiation according to the present invention were treated likewise. Also those results are shown in Table 1.

As obvious from the results shown in Table 1, the use of the polymers having the portions bringing about the decarboxylic reaction by irradiation according to the present invention leads to the obtainment of photosensitive composites having the sensitivity and alkaline water resistance higher than those of photosensitive compositions using the mixtures of the usual polymers and the compounds bringing about the decarboxylic reaction by irradiation.

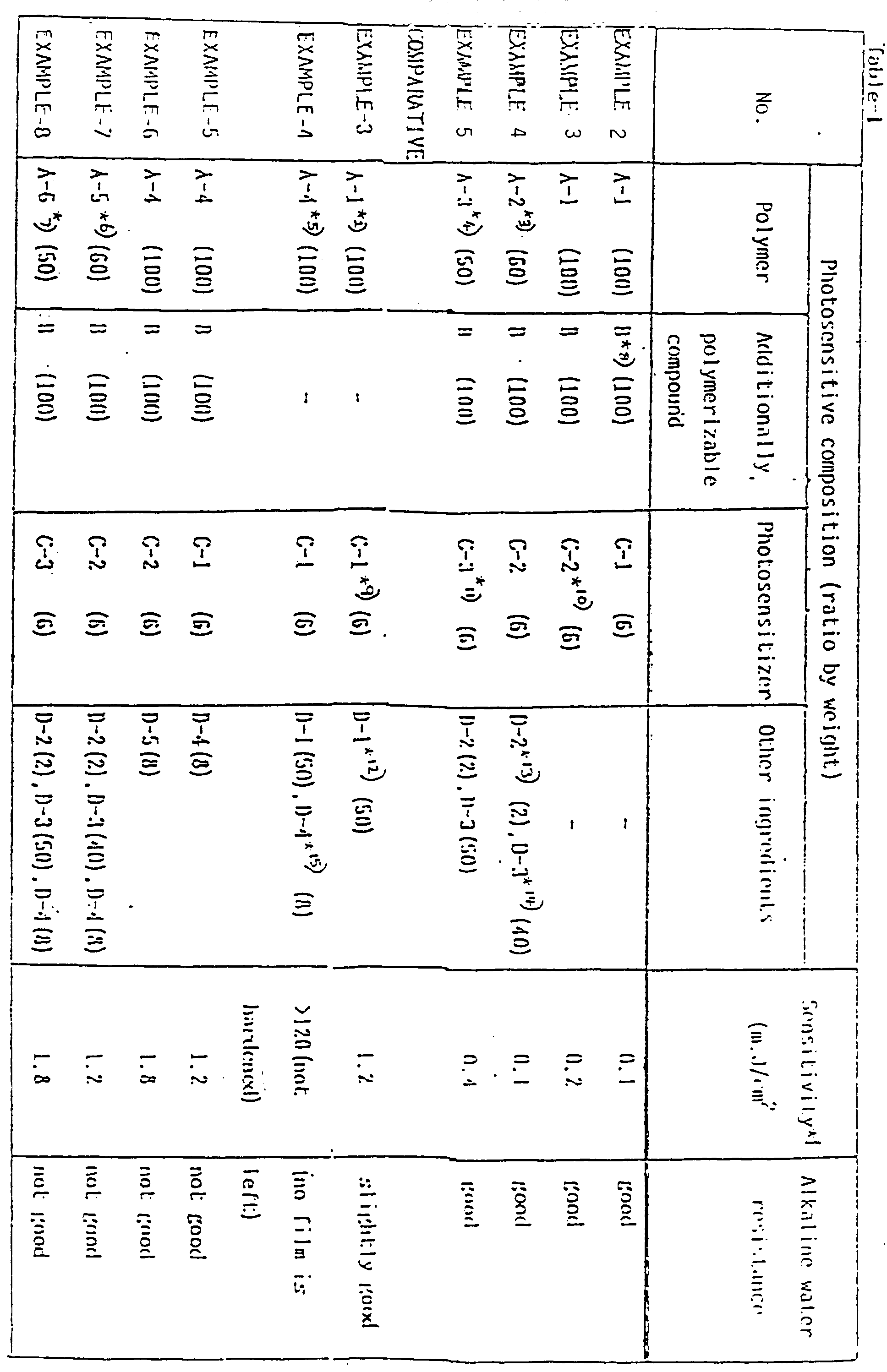

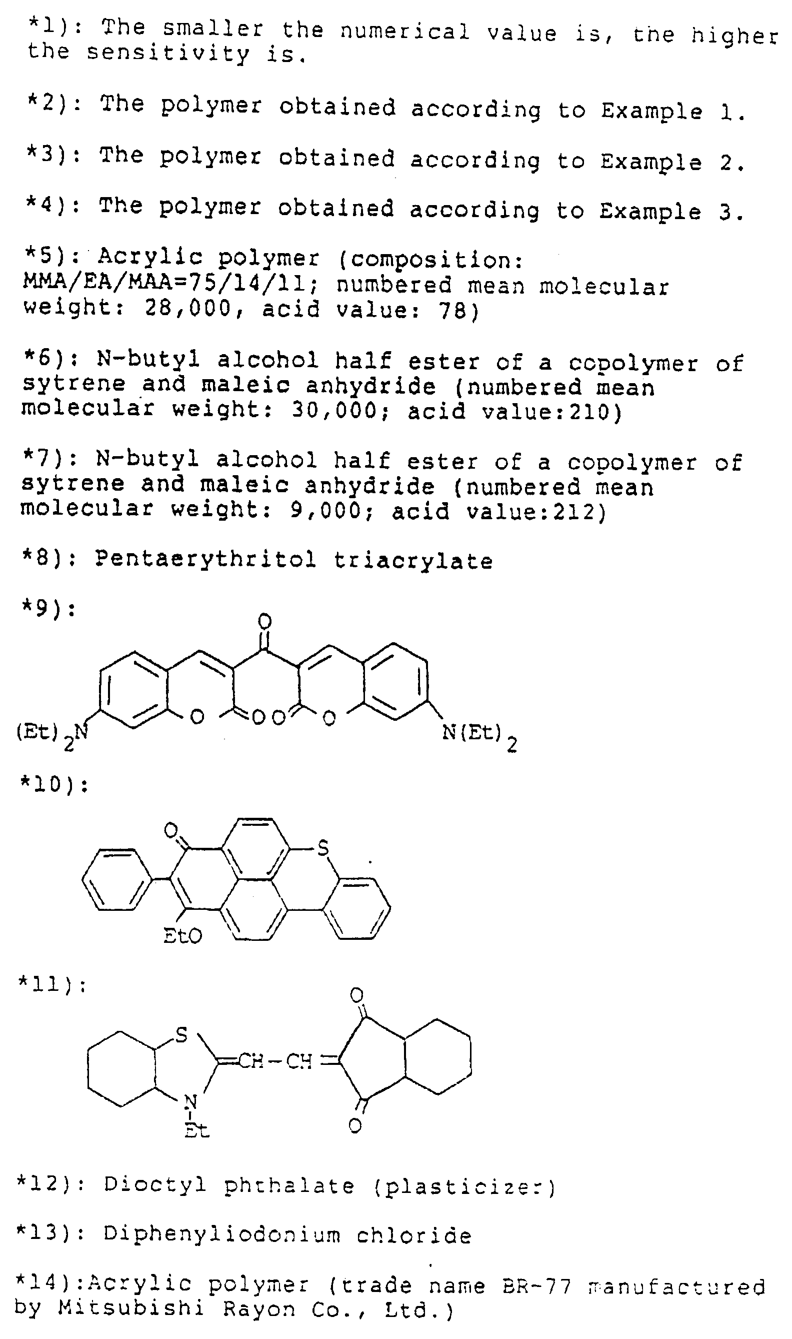

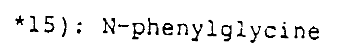

## Claims

1. A photosensitive composition comprising
(a) a polymer having a group represented by the following formula (I) or (II) in a main chain consisting of carbon-carbon bonds: 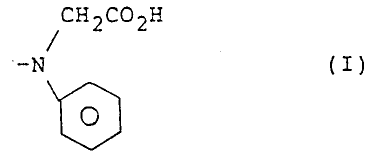 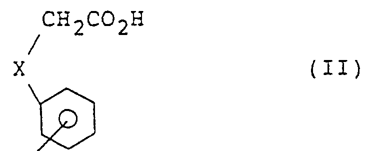 wherein X is an oxygen atom, a sulfur atom or N-R¹,R¹ is a hydrogen atom, an alkyl group containing 1 to 3 carbon atoms or CH₂CO₂H.I; said group being decarboxylated by photoreaction of its own or by photo-reaction with a photo-sensitizer which absorbs a light to generate a free radical,
(b) a compound having an ethylenically unsaturated bond and
(c) a photosensitizer.

2. The composition according to Claim 1 wherein said polymer (a) is a homopolymer of polymerizable compounds having the group (I) or (II).

3. The composition according to Claim 1 wherein said polymer (a) is a copolymer of polymerizable compounds having the group (I) or (II) and other copolymerizable compounds.

4. The composition according to Claim 1 wherein said polymerizable compounds are 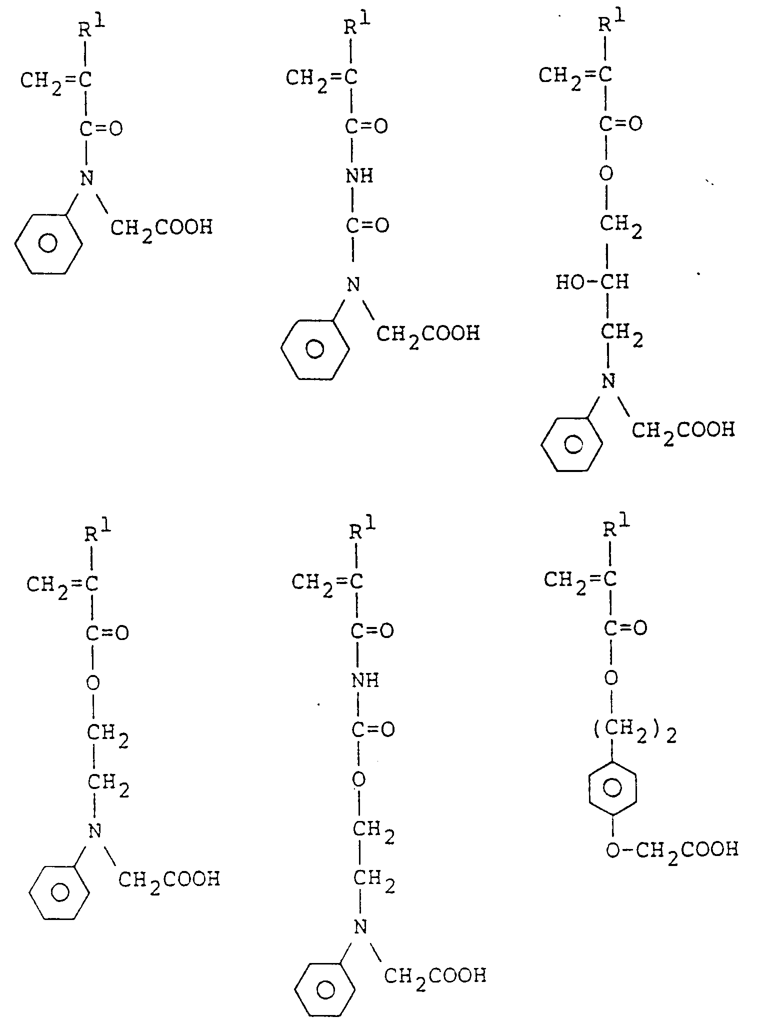 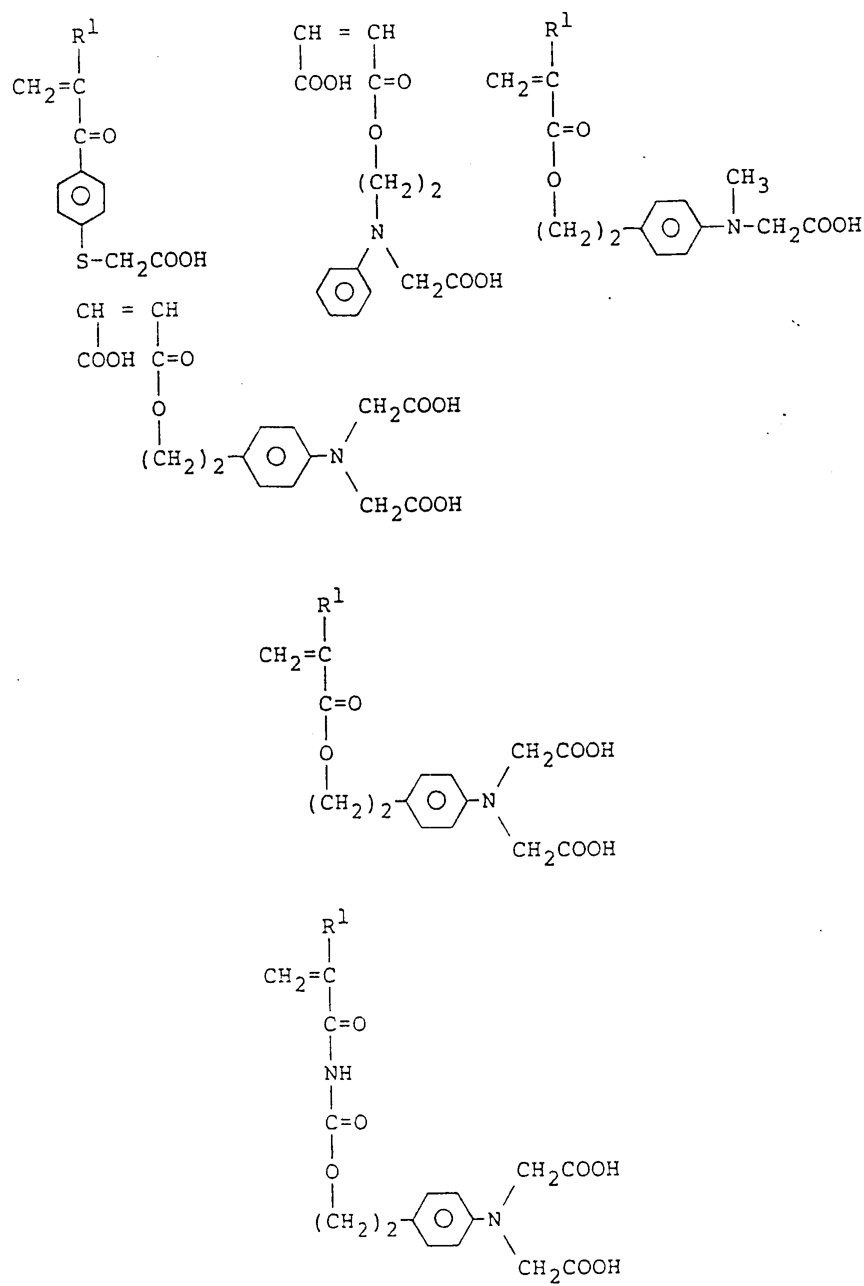 [in the formula R¹ is a hydrogen or methyl group].

5. The composition according to Claim 1 further comprising a diaryliodonium salt.

6. The composition according to Claim 1 further comprising a peroxyester.

## Patentansprüche

1. Fotoempfindliche Zusammensetzung, umfassend
(a) ein Polymer mit einer Gruppe der folgenden Formeln (I) oder (II) in einer Hauptkette, bestehend aus Kohlenstoff-Kohlenstoffbindungen: 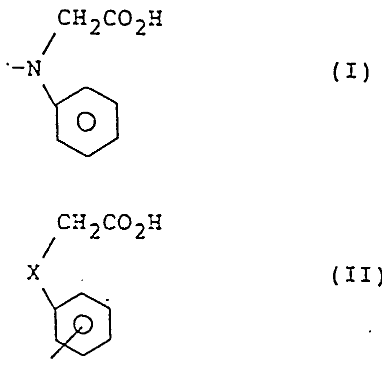 worin X ein Sauerstoffatom, ein Schwefelatom oder N-R¹ ist, R¹ ein Wasserstoffatom, eine Alkylgruppe mit 1 bis 3 Kohlenstoffatomen oder CH₂CO₂H ist; wobei diese Gruppen decarboxyliert sind durch eine eigene Fotoreaktion oder durch eine Fotoreaktion mit einem Sensibilisator, der Licht unter Erzeugung eines freien Radikals absorbiert,
(b) eine Verbindung mit einer ethylenisch ungesättigten Bindung und
(c) einen Sensibilisator.

2. Verbindung gemäß Anspruch 1, in welcher das Polymer (a) ein Homopolymer von polymerisierbaren Verbindung mit den Gruppen (I) oder (II) ist.

3. Verbindung gemäß Anspruch 1, in welcher das Polymer (a) ein Copolymer von polymerisierbaren Verbindungen mit den Gruppen (I) oder (II) und anderen copolymerisierbaren Verbindung ist.

4. Zusammensetzung gemäß Anspruch 1, in welcher die polymerisierbaren Verbindungen 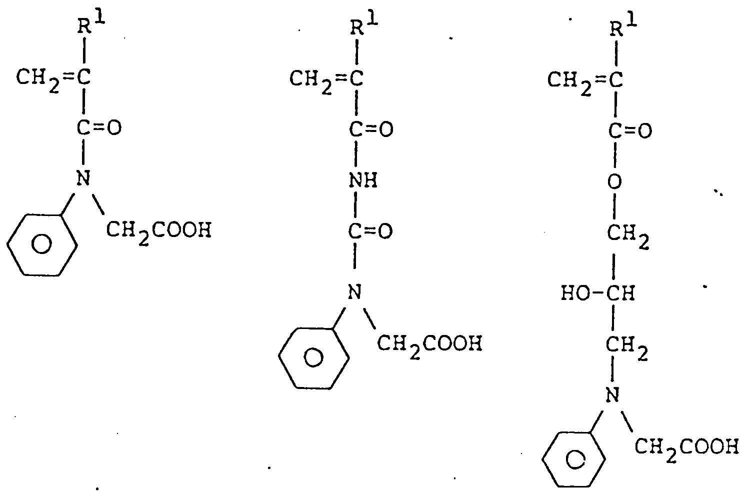 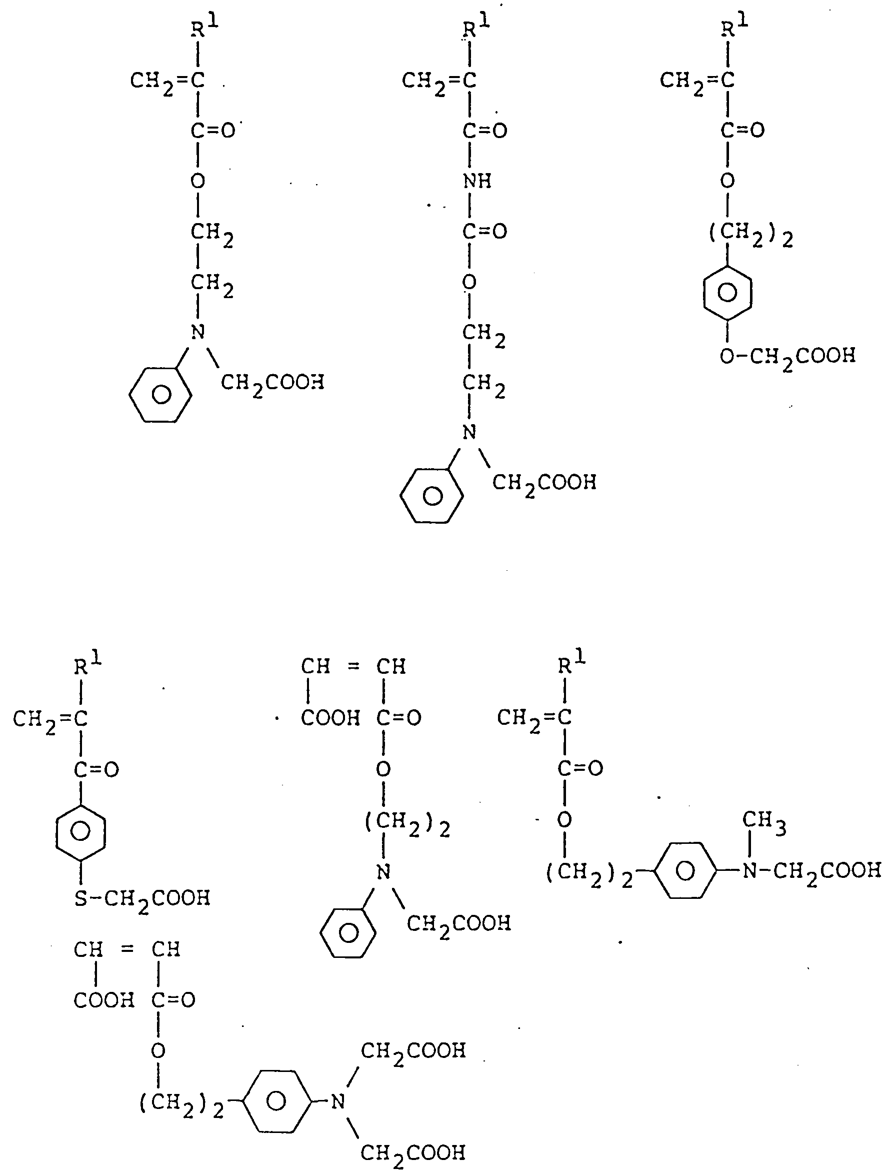 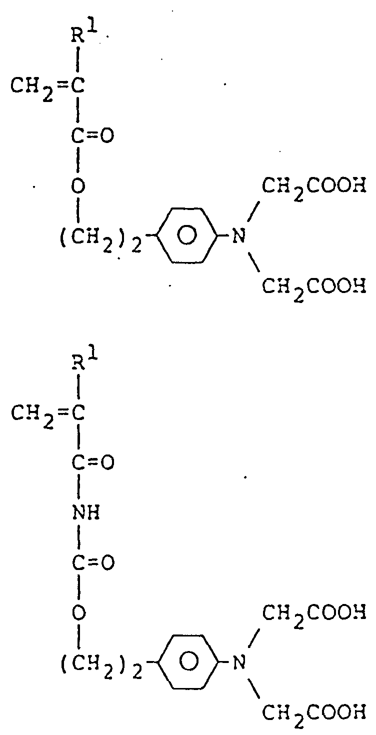 sind, wobei in den Formeln R¹ Wasserstoff oder eine Methylgruppe ist.

5. Zusammensetzung gemäß Anspruch 1, umfassend weiterhin ein Diaryljodoniumsalz.

6. Zusammensetzung gemäß Anspruch 1, umfassend weiterhin einen Peroxyester.

## Revendications

1. Composition photosensible comprenant
(a) un polymère possédant un radical représenté par la formule (I) ou (II) qui suit, dans une chaîne principale se composant de liaisons carbone-carbone: 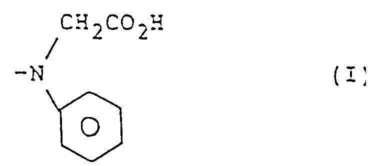 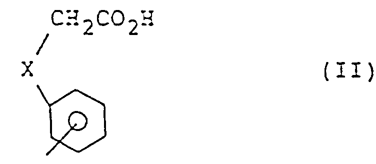 où X représente un atome d'oxygène, un atome de soufre ou N-R¹, R¹ représente un atome d'hydrogène, un radical alkyle contenant 1 à 3 atomes de carbone ou CH₂CO₂H.I, ledit radical étant décarboxylé par une photoréaction propre ou une photoréaction avec un photosensibilisateur qui absorbe la lumière pour produire un radical libre,
(b) un composé présentant une liaison à insaturation éthylénique et
(c) un photosensibilisateur.

2. Composition selon la revendication 1, dans laquelle ledit polymère (a) est un homopolymère de composés polymérisables possédant les groupes (I) ou (II).

3. Composition selon la revendication 1, dans laquelle ledit polymère (a) est un copolymère de composés polymérisables possédant les groupes (I) ou (II) et d'autres composés copolymérisables.

4. Composition selon la revendication 1, dans laquelle lesdits composés polymérisables sont 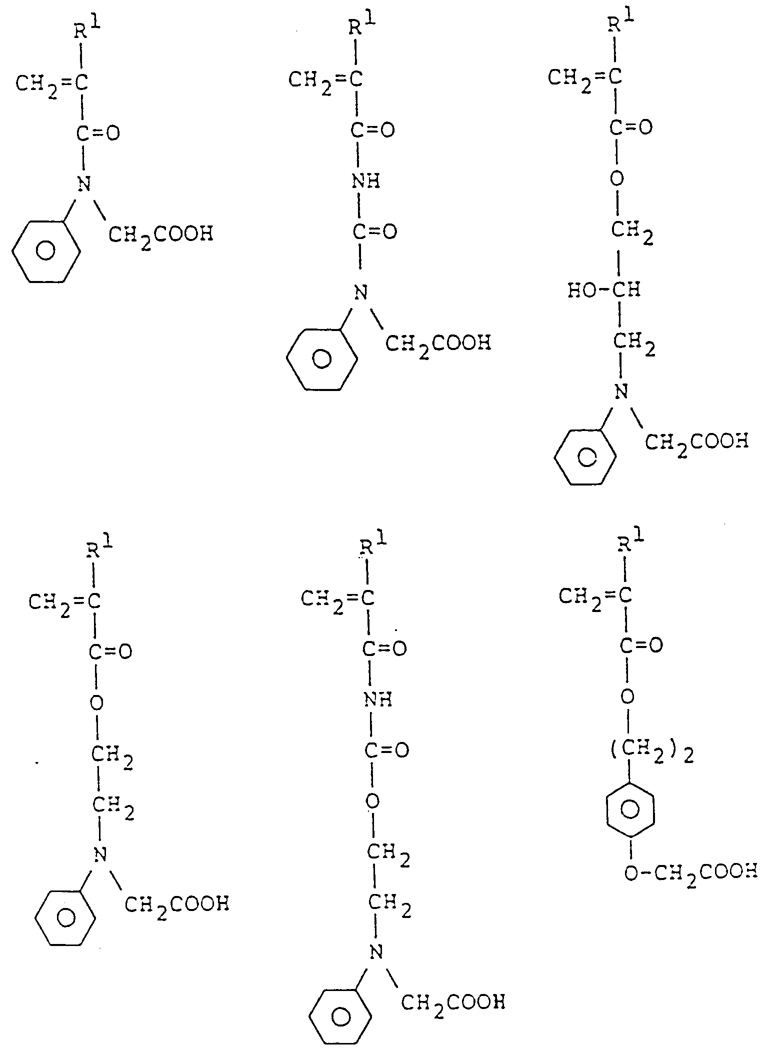 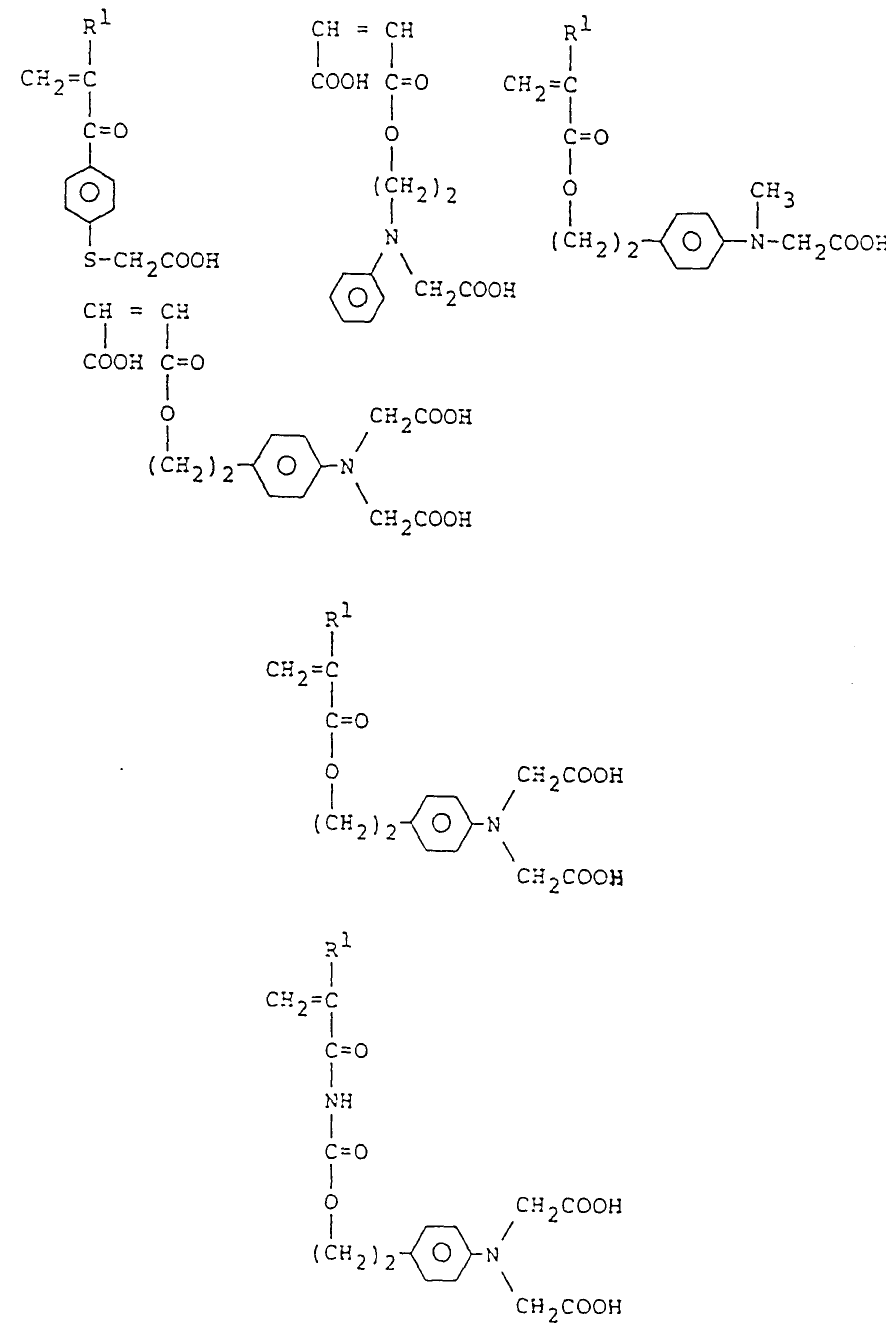 [dans la formule R¹ représente l'hydrogène ou un radical méthyle]

5. Composition selon la revendication 1, comprenant de plus un sel de diaryl-iodonium.

6. Composition selon la revendication 1, comprenant de plus un peroxy-ester.
